# EUROPEAN PATENT APPLICATION

(11) **EP 4 152 094 A1**
(43) Date of publication of application: **22.03.2023**
(21) Application number: 21805081.3
(22) Date of filing: 12.05.2021
(51) Int. Cl.: G03F 1/64

(54) **PELLICLE FRAME, PELLICLE, PELLICLE-ATTACHED EXPOSURE ORIGINAL PLATE, METHOD FOR MANUFACTURING SEMICONDUCTOR, METHOD FOR MANUFACTURING LIQUID CRYSTAL DISPLAY PLATE, AND EXPOSURE METHOD**

(30) Priority: 14.05.2020 JP 2020085355
(71) Applicant: SHIN-ETSU CHEMICAL CO., LTD., Tokyo 1000005 (JP)
(72) Inventor: YANASE, Yu, Annaka-shi, Gunma 379-0127 (JP)
(74) Representative: Held, Stephan
(86) International application number: PCT/JP2021/017960
(87) International publication number: WO 2021/230262

(57) **Abstract**

The present invention provides: a pellicle frame for EUV exposure characterized in that the pellicle frame is provided with at least one ventilation part, and a filter having a porous membrane coated with a resin is attached inside the ventilation part; a pellicle characterized in that a pellicle film is stretched on the pellicle frame; a pellicle-attached exposure original plate for EUV exposure characterized in that the pellicle is attached to the exposure original plate; a method for manufacturing a semiconductor; a method for manufacturing a liquid crystal display plate; and an exposure method. The pellicle frame of the present invention is sufficiently resistant to hydrogen radicals during EUV exposure.

## Description

### TECHNICAL FIELD

This invention relates to a pellicle frame, pellicle, pellicle-covered exposure original, method for manufacturing semiconductor device, method for manufacturing liquid crystal (LC) display panel, and exposure method.

### BACKGROUND ART

In recent years, the miniaturization of the design rule of LSIs is in progress to the sub-quarter-micron order. Concomitantly, the exposure light source becomes shorter in wavelength. Specifically, the exposure light source makes a transition from g-line (436 nm) and i-line (365 nm) of mercury lamps to KrF excimer laser (248 nm) and ArF excimer laser (193 nm). A further study is made on the EUV lithography using extreme ultraviolet (EUV) radiation of main wavelength 13.5 nm.

In the manufacture of semiconductor devices such as LSIs and VLSIs or LC display panels, semiconductor wafers or LC matrices are exposed to light to print patterns. If dust is deposited on lithographic photomasks and reticles (collectively referred to as "exposure original," hereinafter) used herein, the dust absorbs or deflects light, raising such problems that the transferred pattern can be deformed or roughened at the edge, and the background be stained black, detracting from size, quality, appearance and other factors.

Although these operations are generally performed in a cleanroom, it is yet difficult to always maintain the exposure original clean. It is thus a common practice to attach a pellicle to the surface of the exposure original as a dust cover before exposure. In this situation, contaminants do not directly deposit on the surface of the exposure original, but on the pellicle. Now that a focus is set on the pattern of the exposure original during lithographic transfer, the contaminants on the pellicle do not participate in the transfer.

The pellicle is basically constructed such that a pellicle membrane having a high transmittance to radiation used in the exposure is extended on the upper end surface of a pellicle frame made of aluminum or titanium, and a gas-tight gasket is formed on the lower end surface of the pellicle frame. A pressure-sensitive adhesive (PSA) layer is generally used as the gas-tight gasket. A protective sheet is attached to the PSA layer for protection purpose. While the pellicle membrane is made of nitrocellulose, cellulose acetate, and fluoro-polymers which are fully transmissive to radiation used in the exposure such as g-line (436 nm) or i-line (365 nm) of mercury lamps, KrF excimer laser (248 nm) or ArF excimer laser (193 nm), a very thin silicon membrane or carbon membrane is investigated as the pellicle membrane for the EUV lithography.

As the filter for the pellicle, porous films as used in high-efficiency particulate air (HEPA) filters and ultra-low penetration air (ULPA) filters are used because of their contaminant-capturing capability. For the EUV lithography pellicle, a study is made on the use of analogous filters as described in Patent Document 1.

However, the interior of the EUV exposure apparatus is filled with hydrogen gas for efficient removal of contaminants, known as scattering debris, which are generated upon emission of EUV radiation. The EUV radiation acts on hydrogen gas to generate hydrogen radicals. The EUV lithography pellicle is thus required to have high resistance to hydrogen radicals, which is not needed in the prior art KrF and ArF lithography pellicles.

In general, the filter has a porous film for collecting contaminants so that upon passage of gas through pores in the porous film, the porous film captures contaminants and only contaminant-free gas passes across the film. It is readily understood that because of its properties, the porous film has the largest surface area and the most chance of exposure to hydrogen radical-containing gas among the members of which the pellicle is composed. As a result, the porous film is degraded by hydrogen radicals and its contaminant capture rate can be reduced as pores are enlarged. For this reason, the porous film used in the filter is required to have high hydrogen radical resistance.

### PRIOR ART DOCUMENTS

### PATENT DOCUMENTS

Patent Document 1: WO 2016/043292

### SUMMARY OF INVENTION

### TECHNICAL PROBLEM

An object of the invention, which has been made under the above-mentioned circumstances, is to provide a pellicle frame having satisfactory resistance to hydrogen radicals in the EUV lithography, a pellicle comprising the pellicle frame, a pellicle-covered exposure original, a method for manufacturing a semiconductor device, a method for manufacturing a LC display panel, and an exposure method.

### SOLUTION TO PROBLEM

Making extensive investigations to attain the above object, the inventor has found that the object of providing a pellicle frame having satisfactory resistance to hydrogen radicals in the EUV lithography is attained by providing the pellicle frame with a ventilating port and attaching a filter having a resin-coated porous film inside the ventilating port, and preferably by using a silicone or epoxy resin as the resin for coating the porous film. The invention is predicated on this finding.

Accordingly, the invention provides a pellicle frame, pellicle, pellicle-covered exposure original, method for manufacturing semiconductor device, method for manufacturing LC display panel, and exposure method as defined below.
1. A pellicle frame for EUV lithography wherein the pellicle frame is provided with at least one ventilating port, and a filter having a resin-coated porous film is attached inside the ventilating port.
2. The pellicle frame of 1 wherein the porous film is a resinous porous film made of at least one resin selected from the group consisting of a fluoro-resin, polyester resin, polyimide resin, polycarbonate resin, and polyolefin resin.
3. The pellicle frame of 1 wherein the porous film is a porous film of polytetrafluoroethylene.
4. The pellicle frame of 1 or 2 wherein the resin with which the porous film is coated is a silicone resin or epoxy resin.
5. The pellicle frame of 1 or 2 wherein the filter has an air-permeable support layer for supporting the porous film.
6. The pellicle frame of 1 or 2 wherein the porous film has a plurality of nodes and a plurality of fibrils, and adjacent nodes are connected by the fibril.
7. The pellicle frame of 5 wherein the air-permeable support layer is in at least one form selected from the group consisting of woven fabric, non-woven fabric, net and mesh.
8. The pellicle frame of 1 or 2, having a thickness of less than 2.5 mm.
9. A pellicle for EUV lithography, comprising the pellicle frame of 1 and a pellicle membrane extended on the frame.
10. The pellicle of 9, having a height of up to 2.5 mm.
11. The pellicle of 9 or 10 wherein the pellicle membrane is a pellicle membrane held by a rim.
12. A pellicle-covered exposure original comprising an exposure original and the pellicle of 9 mounted thereon.
13. The pellicle-covered exposure original of 12 wherein the exposure original is an exposure original for EUV lithography.
14. The pellicle-covered exposure original of 12 which is a pellicle-covered exposure original for use in EUV lithography.
15. An exposure method comprising the step of exposing to EUV radiation through the pellicle-covered exposure original of 12.
16. A method for manufacturing a semiconductor device comprising the step of EUV exposure through the pellicle-covered exposure original of 12.
17. A method for manufacturing a liquid crystal display panel comprising the step of EUV exposure through the pellicle-covered exposure original of 12.
18. A pellicle frame for use in a hydrogen plasma environment, wherein the pellicle frame is provided with at least one ventilating port, and a filter having a resin-coated porous film is attached inside the ventilating port.
19. The pellicle frame of 18 wherein the porous film is a resinous porous film made of at least one resin selected from the group consisting of a fluoro-resin, polyester resin, polyimide resin, polycarbonate resin, and polyolefin resin.
20. The pellicle frame of 18 wherein the porous film is a porous film of polytetrafluoroethylene.
21. The pellicle frame of 18 or 19 wherein the resin with which the porous film is coated is a silicone resin or epoxy resin.
22. The pellicle frame of 18 or 19 wherein the filter has a air-permeable support layer for supporting the porous film.
23. The pellicle frame of 18 or 19 wherein the porous film has a plurality of nodes and a plurality of fibrils, and adjacent nodes are connected by the fibril.
24. The pellicle frame of 22 wherein the air-permeable support layer is in at least one form selected from the group consisting of woven fabric, non-woven fabric, net and mesh.
25. The pellicle frame of 18 or 19, having a thickness of less than 2.5 mm.
26. A pellicle for use in a hydrogen plasma environment, comprising the pellicle frame of 18 and a pellicle membrane extended on the frame.
27. The pellicle of 26, having a height of up to 2.5 mm.
28. The pellicle of 26 or 27 wherein the pellicle membrane is a pellicle membrane held by a rim.
29. A pellicle-covered exposure original for use in a hydrogen plasma environment, comprising an exposure original and the pellicle of 26 mounted thereon.
30. The pellicle-covered exposure original of 29 wherein the exposure original is an exposure original for EUV lithography.
31. The pellicle-covered exposure original of 29 which is a pellicle-covered exposure original for use in EUV lithography.
32. An exposure method comprising the step of exposure through the pellicle-covered exposure original of 29 in a hydrogen plasma environment.
33. A method for manufacturing a semiconductor device comprising the step of exposure through the pellicle-covered exposure original of 29 in a hydrogen plasma environment.
34. A method for manufacturing a liquid crystal display panel comprising the step of exposure through the pellicle-covered exposure original of 29 in a hydrogen plasma environment.

### ADVANTAGEOUS EFFECTS OF INVENTION

According to the invention, a pellicle frame and a pellicle having satisfactory resistance to hydrogen radicals in the EUV lithography are provided. They are useful in an EUV exposure method, semiconductor device manufacturing method, and LC display panel manufacturing method using a pellicle-covered exposure original.

### BRIEF DESCRIPTION OF DRAWINGS

[FIG. 1] FIG. 1 is a plan view of a pellicle frame according to one embodiment of the invention.
[FIG. 2] FIG. 2 is a schematic cross-sectional view of the pellicle frame taken along lines A-A in FIG. 1, illustrating a ventilating port and a filter.

### DESCRIPTION OF EMBODIMENTS

Now the invention is described in detail.

The invention provides a pellicle frame in a frame shape having an upper end surface adapted to bear a pellicle membrane and a lower end surface adapted to face a photomask.

As long as the pellicle frame is in a frame shape, its shape corresponds to the shape of a photomask on which a pellicle is mounted. In general, it is a four-sided (rectangular or square) frame. The shape of corners or edges of the pellicle frame may be an angular or pointed shape as primarily machined or another shape, typically curvilinear shape as homed or chamfered such as by rounding or chamfering.

The pellicle frame further has a surface (referred to as upper end surface) on which a pellicle membrane is to be extended and a surface (referred to as lower end surface) adapted to face a photomask when the frame is mounted on the photomask.

In general, the pellicle frame is provided on its upper end surface with a pellicle membrane via an adhesive and on its lower end surface with a PSA layer for mounting the pellicle on the photomask although the invention is not limited thereto.

While the material of the pellicle frame is not particularly limited, any well-known material may be used. Since the pellicle frame for the EUV lithography can be exposed to high temperature, a material having a low coefficient of thermal expansion is preferred. Exemplary materials include Si, SiO₂, SiN, quartz, Invar, titanium and titanium alloys. Inter alia, titanium and titanium alloys are preferred for ease of working and light weight.

The size of the pellicle frame is not particularly limited. Since the height of the pellicle for the EUV lithography is limited to 2.5 mm or less, the thickness of the pellicle frame for the EUV lithography is smaller than the height, i.e., less than 2.5 mm.

The thickness of the pellicle frame for the EUV lithography is preferably equal to or less than 1.5 mm in view of the thickness of the pellicle film and mask PSA. The lower limit of thickness of the pellicle frame is preferably at least 1.0 mm.

Also, the side surface of the pellicle frame is typically provided with a jig hole which is utilized during handling or dismounting of the pellicle from the photomask. With respect to the size of the jig hole, the length of the jig hole in thickness direction of the pellicle frame (diameter in the case of a circular hole) is 0.5 to 1.0 mm. While the shape of the hole is not particularly limited, it may be either circular or rectangular.

According to the invention, the pellicle frame is provided with a ventilating port for mitigating a change of pressure across the pellicle. The shape and number of the ventilating port(s) are not particularly limited. The ventilating port is provided with a filter for preventing contaminant ingress into the pellicle interior. The location site of the filter is not particularly limited, that is, the filter may be disposed inside the pellicle frame, inside the ventilating port, or outside the pellicle frame.

The pellicle frame of the invention is characterized by comprising a filter having a porous film coated with a hydrogen radical-resistant resin. Though not particularly limited, the porous film is preferably made of at least one resin selected from the group consisting of fluoro-resins, polyester resins, polyimide resins, polycarbonate resins, and polyolefin resins. Among these, the fluoro-resins which have been used in KrF and ArF lithography pellicles are more preferred, with polytetrafluoroethylene (PTFE) being most preferred.

The PTFE porous film is generally composed of nodes which are aggregates of PTFE and a multiplicity of fibrils in the form of minute fibrous structures, each linked at both ends to the nodes. Adjacent nodes are connected by the fibril. The PTFE porous film has such air permeability in film thickness direction that voids or pores between adjoining fibrils become ventilating passages. The PTFE porous film is also known as stretched porous film and formed by stretching a PTFE sheet which is an aggregate of PTFE. By stretching a PTFE sheet, nodes and fibrils are formed and their arrangement varies, for example, with the PTFE sheet stretching conditions.

The resin with which the porous film is coated should preferably have sufficient resistance to hydrogen radicals. Illustrative examples include silicone resins, epoxy resins, acrylic resins, fluoro-resins and urethane resins. Among these, silicone resins and epoxy resins are preferred from the standpoint of hydrogen radical resistance, with the silicone resins being more preferred. Although it is not critical how to coat a porous film with a resin, a method involving the steps of preparing a resin solution and impregnating a porous film with the solution is easy and preferable. Although it is not critical how to impregnate the porous film with the resin solution, for example, methods of dipping the porous film in the resin solution, spin coating the resin solution to the porous film, and spraying the resin solution to the porous film are possible. On use of the resin solution, the solution can quickly spread into gaps in the porous film to coat fibers of the porous film with the resin. As used herein, the coating of the porous film with the resin does not necessarily require that the overall surface of the porous film be coated with the resin. The coating weight and percent coverage may be adjusted in accordance with the desired level of hydrogen radical resistance. By crosslinking and curing the resin with the aid of light or heat, the resin can be improved in hydrogen radical resistance.

In the practice of the invention, the filter may include another optional member other than the porous film. The other member is, for example, an air-permeable support layer. In this embodiment, the filter includes the porous film and an air-permeable support layer disposed on one major surface of the porous film. By disposing the air-permeable support layer, the filter is improved in strength and becomes easier to handle.

The air-permeable support layer is preferably a layer having higher air permeability and moisture permeability in thickness direction than the porous film. For the air-permeable support layer, for example, woven fabric, non-woven fabric, net or mesh may be used. The material of which the air-permeable support layer is made is, for example, polyester, polyethylene and aramide resins. The shape of the air-permeable support layer may be identical with or different from the shape of the porous film. The air-permeable support layer is attached to the porous film, for example, by such means as heat fusion or adhesive bonding. The air-permeable support layer may be disposed on one major surface or both major surfaces of the porous film. The air-permeable support layer may be coated with the above-mentioned resin.

Although the material of the pellicle membrane is not particularly limited, a material having a high transmittance at the wavelength of the exposure light source and high light resistance is preferred. For example, a very thin silicon membrane, carbon membrane or the like is used in the EUV lithography. Examples of the carbon membrane include membranes of graphene, diamond-like carbon, and carbon nanotubes. When it is difficult to handle the pellicle membrane alone, a pellicle membrane supported by a rim of silicon or the like may be used. In this case, a pellicle can be readily constructed by bonding the region of the rim to the pellicle frame.

The pellicle of the invention includes the pellicle frame and a pellicle membrane disposed on the upper end surface thereof via a PSA or adhesive. While the material of the PSA or adhesive is not particularly limited, any well-known ones may be used. A PSA or adhesive having a strong bonding force is preferred for firmly holding the pellicle membrane.

Further, the pellicle frame is provided on its lower end surface with a mask PSA for mounting the frame on a photomask. In general, the mask PSA is preferably extended along the overall periphery of the pellicle frame.

The mask PSA used herein may be any of well-known ones, with acrylic PSA and silicone-based PSA being preferably used. The PSA may be worked to any desired shape if necessary.

To the lower end surface of the mask PSA, a release layer or separator may be attached for protecting the PSA. While the material of the release layer is not particularly limited, use may be made of polyethylene terephthalate (PET), polytetrafluoroethylene (PTFE), tetrafluoroethylene-perfluoroalkyl vinyl ether copolymers (PFA), polyethylene (PE), polycarbonate (PC), polyvinyl chloride (PVC), and polypropylene (PP), for example. Also, if necessary, such release agents as silicone-based release agents and fluorochemical release agents may be coated on the surface of the release layer.

The pellicle of the invention may serve not only as a protective member for protecting an exposure original from particulate contamination in an exposure unit, but also as a protective member for protecting an exposure original during its storage or transportation. In preparing a pellicle-covered exposure original by mounting a pellicle on an exposure original, typically photomask, an electrostatic chucking method, mechanical securing method or the like may be used as well as the aforementioned method of bonding with the mask PSA.

A further embodiment of the invention is a method for manufacturing a semiconductor device or LC display panel, which includes the step of exposing a substrate (semiconductor wafer or LC matrix) to radiation through the pellicle-covered exposure original. For example, in the lithography step which is one of the steps of the process of manufacturing a semiconductor device or LC display panel, the stepper is installed with the pellicle-covered exposure original and exposure is performed to form a photoresist pattern corresponding to an integrated circuit or the like on a substrate. In general, a projection optical system is used in the EUV lithography such that EUV radiation is reflected by the exposure original and directed to the substrate. The exposure step is performed under reduced pressure or in vacuum. Even when contaminants deposit on the pellicle in the lithography step, the contaminants are out of focus on the photoresist-coated wafer, preventing the images of contaminants from causing short- or open-circuiting in the integrated circuit. Therefore, the yield of the lithography step can be improved by using the pellicle-covered exposure original.

### EXAMPLES

Examples and Comparative Examples are given below for illustrating the invention, but the invention is not limited thereto.

### [Evaluation of hydrogen radical resistance of filter]

There was furnished a filter (TEMISH S-NTF 1033-N01 by Nitto Denko Corp.) consisting of a 15-cm square porous film of polytetrafluoroethylene (PTFE porous film) and a mesh-form support of polypropylene. The filter was spin coated with a 1 wt% solution of each of the following resins (1) to (6) at 800 rpm for 60 seconds, which was air dried at room temperature for 12 hours to volatilize off the solvent.
(1) silicone resin base PSA
(2) epoxy resin base PSA
(3) acrylic resin base PSA
(4) fluoro-resin
(5) urethane resin base PSA
(6) untreated

The filter coated with the resin was subjected to hydrogen plasma exposure in the system shown below.

### (Hydrogen plasma exposure conditions)

| | |
|---|---|
| System: | FlexAL by Oxford Instruments |
| Plasma source: | inductively coupled plasma (ICP) |
| Treating conditions: | pressure 80 mTorr, H₂ flow rate 50 sccm |
| Power: | 200 W |
| Treating temperature: | 100°C |
| Treating time: | 600 s |

After the hydrogen plasma exposure, the filter was observed under a microscope (Eclipse LV150 by Nikon Corp.) and judged as follows. The results are shown in Table 1.

### (Judgment criterion)

A: It was confirmed that PTFE porous film remained,
   with the filter structure unchanged.
B: It was confirmed that PTFE porous film was lost.

**[Table 1]**

| Resin type | Judgment result |
|---|---|
| (1) Silicone resin | A |
| (2) Epoxy resin | A |
| (3) Acrylic resin | B |
| (4) Fluoro-resin | B |
| (5) Urethane resin | B |
| (6) Untreated | B |

It is seen from the results of Table 1 that a filter having a porous film coated with silicone resin or epoxy resin has excellent hydrogen plasma resistance. For those filters having porous films coated with acrylic resin, fluoro-resin and urethane resin tested under the above-described conditions, the porous films were lost by hydrogen plasma exposure. It is confirmed that these filters are still superior over the untreated filter when the power of hydrogen plasma is reduced, the temperature is lowered, or the treating time is shortened.

### [Example 1]

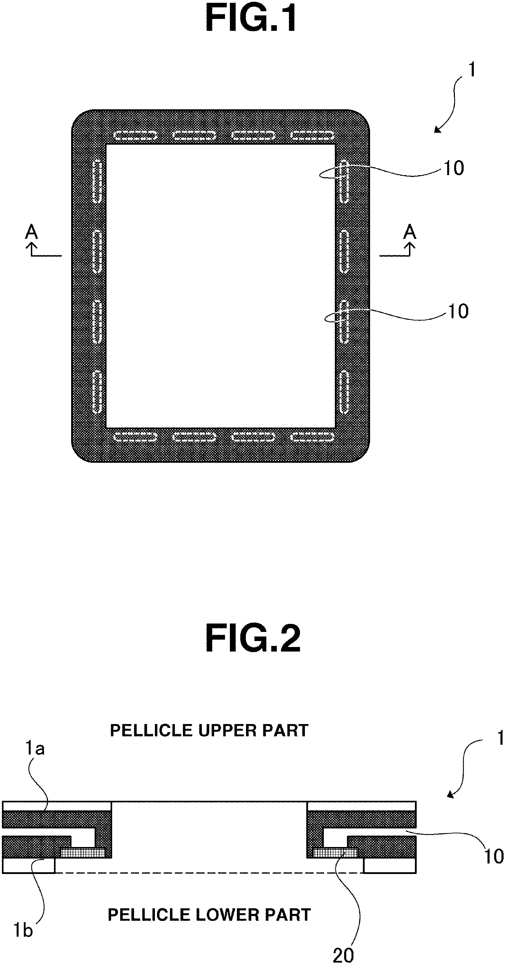

There was furnished a pellicle frame (outer dimensions 150 mm × 118 mm × 1.5 mm, width 4.0 mm) of titanium. As shown in FIGS. 1 and 2, the pellicle frame 1 was provided with a ventilating port 10 of L shape which extends from the outside to the lower end surface of the frame. In FIGS. 1 and 2, the pellicle frame 1 has an upper end surface 1a and a lower end surface 1b. The pellicle frame 1 is provided at an opening in the lower end surface with a filter 20, which is coated with a selected resin though not shown.

There was furnished a filter of 10 mm long and 2.5 mm wide (TEMISH S-NTF 1033-N01 by Nitto Denko Corp.) consisting of a PTFE porous film and a mesh-form support of polypropylene. Subsequently, 1 part by weight of curing agent (PT-56 by Shin-Etsu Chemical Co., Ltd.) was added to 100 parts by weight of silicone resin base PSA (X-40-3264 by Shin-Etsu Chemical Co., Ltd.), the mixture was stirred, and the mixture was dissolved in a hydrocarbon solvent (Isopar E by Exxon Mobil Corp.) to form a 1 wt% solution. The filter at its center was impregnated with 1 mL of the solution, followed by air drying at room temperature for 2 hours until the solvent was completely volatilized off. The filter designated at 20 in FIG. 2 was attached to the opening in the lower end surface of the pellicle frame with a double-side tape.

The pellicle frame was washed with a neutral detergent and pure water. Then a material obtained by adding 1 part by weight of curing agent (PT-56 by Shin-Etsu Chemical Co., Ltd.) to 100 parts by weight of silicone resin base PSA (X-40-3264 by Shin-Etsu Chemical Co., Ltd.) and stirring was coated onto the upper end surface of the frame to form a PSA layer of 1 mm wide and 0.1 mm thick. A mask PSA obtained by adding 0.1 part by weight of curing agent (L-45 by Soken Chemical & Engineering Co., Ltd.) to 100 parts by weight of acrylic resin base PSA (SK-Dyne 1499M by Soken Chemical & Engineering Co., Ltd.) and stirring was coated onto the lower end surface of the pellicle frame to form a layer of 1 mm wide and 0.1 mm thick along the overall periphery.

Thereafter, the pellicle frame was heated at 100°C for 12 hours to cure the PSA layers on the upper and lower end surfaces. Subsequently, a very thin silicon membrane as the pellicle membrane was compression bonded to the PSA layer on the upper end surface of the pellicle frame to complete a pellicle.

### [Example 2]

There was furnished a filter of 10 mm long and 2.5 mm wide (TEMISH S-NTF 1033-N01 by Nitto Denko Corp.) consisting of a PTFE porous film and a mesh-form support of polypropylene. Subsequently, epoxy resin base adhesive (1001T75 by Mitsubishi Chemical Co., Ltd.) was dissolved in toluene to form a 1 wt% solution. The filter at its center was impregnated with 1 mL of the solution, followed by air drying at room temperature for 2 hours until the solvent was completely volatilized off. The filter was attached to the opening in the lower end surface of the pellicle frame with a double-side tape. Otherwise, the procedure is the same as in Example 1 to complete a pellicle.

As seen from Examples 1 and 2, there is provided a pellicle having a filter having hydrogen radical resistance.

### REFERENCE SIGNS LIST

- 1: pellicle frame
- 1a: pellicle frame upper end surface
- 1b: pellicle frame lower end surface
- 10: ventilating port
- 20: filter

## Claims

1. A pellicle frame for EUV lithography wherein the pellicle frame is provided with at least one ventilating port, and a filter having a resin-coated porous film is attached inside the ventilating port.

2. The pellicle frame of claim 1 wherein the porous film is a resinous porous film made of at least one resin selected from the group consisting of a fluoro-resin, polyester resin, polyimide resin, polycarbonate resin, and polyolefin resin.

3. The pellicle frame of claim 1 wherein the porous film is a porous film of polytetrafluoroethylene.

4. The pellicle frame of claim 1 or 2 wherein the resin with which the porous film is coated is a silicone resin or epoxy resin.

5. The pellicle frame of claim 1 or 2 wherein the filter has an air-permeable support layer for supporting the porous film.

6. The pellicle frame of claim 1 or 2 wherein the porous film has a plurality of nodes and a plurality of fibrils, and adjacent nodes are connected by the fibril.

7. The pellicle frame of claim 5 wherein the air-permeable support layer is in at least one form selected from the group consisting of woven fabric, non-woven fabric, net and mesh.

8. The pellicle frame of claim 1 or 2, having a thickness of less than 2.5 mm.

9. A pellicle for EUV lithography, comprising the pellicle frame of claim 1 and a pellicle membrane extended on the frame.

10. The pellicle of claim 9, having a height of up to 2.5 mm.

11. The pellicle of claim 9 or 10 wherein the pellicle membrane is a pellicle membrane held by a rim.

12. A pellicle-covered exposure original comprising an exposure original and the pellicle of claim 9 mounted thereon.

13. The pellicle-covered exposure original of claim 12 wherein the exposure original is an exposure original for EUV lithography.

14. The pellicle-covered exposure original of claim 12 which is a pellicle-covered exposure original for use in EUV lithography.

15. An exposure method comprising the step of exposing to EUV radiation through the pellicle-covered exposure original of claim 12.

16. A method for manufacturing a semiconductor device comprising the step of EUV exposure through the pellicle-covered exposure original of claim 12.

17. A method for manufacturing a liquid crystal display panel comprising the step of EUV exposure through the pellicle-covered exposure original of claim 12.

18. A pellicle frame for use in a hydrogen plasma environment, wherein the pellicle frame is provided with at least one ventilating port, and a filter having a resin-coated porous film is attached inside the ventilating port.

19. The pellicle frame of claim 18 wherein the porous film is a resinous porous film made of at least one resin selected from the group consisting of a fluoro-resin, polyester resin, polyimide resin, polycarbonate resin, and polyolefin resin.

20. The pellicle frame of claim 18 wherein the porous film is a porous film of polytetrafluoroethylene.

21. The pellicle frame of claim 18 or 19 wherein the resin with which the porous film is coated is a silicone resin or epoxy resin.

22. The pellicle frame of claim 18 or 19 wherein the filter has a air-permeable support layer for supporting the porous film.

23. The pellicle frame of claim 18 or 19 wherein the porous film has a plurality of nodes and a plurality of fibrils, and adjacent nodes are connected by the fibril.

24. The pellicle frame of claim 22 wherein the air-permeable support layer is in at least one form selected from the group consisting of woven fabric, non-woven fabric, net and mesh.

25. The pellicle frame of claim 18 or 19, having a thickness of less than 2.5 mm.

26. A pellicle for use in a hydrogen plasma environment, comprising the pellicle frame of claim 18 and a pellicle membrane extended on the frame.

27. The pellicle of claim 26, having a height of up to 2.5 mm.

28. The pellicle of claim 26 or 27 wherein the pellicle membrane is a pellicle membrane held by a rim.

29. A pellicle-covered exposure original for use in a hydrogen plasma environment, comprising an exposure original and the pellicle of claim 26 mounted thereon.

30. The pellicle-covered exposure original of claim 29 wherein the exposure original is an exposure original for EUV lithography.

31. The pellicle-covered exposure original of claim 29 which is a pellicle-covered exposure original for use in EUV lithography.

32. An exposure method comprising the step of exposure through the pellicle-covered exposure original of claim 29 in a hydrogen plasma environment.

33. A method for manufacturing a semiconductor device comprising the step of exposure through the pellicle-covered exposure original of claim 29 in a hydrogen plasma environment.

34. A method for manufacturing a liquid crystal display panel comprising the step of exposure through the pellicle-covered exposure original of claim 29 in a hydrogen plasma environment.
